# EUROPEAN PATENT SPECIFICATION

(11) **EP 2 063 441 B1**
(45) Date of publication and mention of the grant of the patent: **25.05.2016**
(21) Application number: 07806422.7
(22) Date of filing: 30.08.2007
(51) Int. Cl.: H01G 7/06, H01G 4/12, H01G 4/33

(54) **CAPACITOR AND HIGH FREQUENCY COMPONENT**
KONDENSATOR UND HOCHFREQUENZKOMPONENTE
CONDENSATEUR ET COMPOSANT HAUTE FRÉQUENCE

(30) Priority: 30.08.2006 JP 2006233297; 28.03.2007 JP 2007084510
(43) Date of publication of application: 27.05.2009
(73) Proprietor: Kyocera Corporation, Kyoto-shi Kyoto 612-8501 (JP)
(72) Inventor: TAKI, Kenji, Kyoto 619-0237 (JP)
(74) Representative: Viering, Jentschura & Partner mbB Patent- und Rechtsanwälte
(86) International application number: PCT/JP2007/066945
(87) International publication number: WO 2008/026708

(56) References cited:
- JP-A- 2000 022 083
- JP-A- 2000 022 083
- JP-A- 2003 224 033
- JP-A- 2006 173 367
- JP-A- 2006 196 871
- JP-A- 2006 196 871
- JP-A- 2007 184 499
- US-A- 5 192 871

## Description

### Technical Field

The present invention relates to a capacitor and a high frequency component in which a dielectric layer is formed by a thin film formation method.

### Background Art

There are variable capacitors including barium strontium titanate ((BaₓSr₁₋ₓ)_{y}Ti₁₋yO_{3-z}, where 0<y<1, and 0≤z<3) or the like as a material of a thin film dielectric layer thereof in which, by providing a predetermined bias potential between an upper electrode layer and a lower electrode layer, dielectric constant of the thin film dielectric layer is changed to vary the capacitance of the variable capacitor(for example, see Japanese Unexamined Patent Publication JP-A 11-260667 (1999)).

This variable capacitor has a structure in which a thin film lower electrode layer, a thin film dielectric layer, and a thin film upper electrode layer are layered in this order on an insulating support substrate, with the lower electrode layer and the upper electrode layer each being formed by a sputtering method, a vacuum depositing method, or the like, and the thin film dielectric layer being formed by a sputtering method, a sol-gel method, or the like. A photolithography technique is ordinarily used as a method for patterning each layer. First, after forming a conductor layer that serves as the lower electrode layer on the entire upper face of the insulating support substrate, only necessary portions of the conduct layer are covered with a photoresist that is patterned by photolithography, and afterward, unnecessary portions of the conduct layer are removed by wet etching or dry etching, thus forming the lower electrode layer with a predetermined shape. Next, a dielectric that serves as the thin film dielectric layer is formed on the entire surface of this support substrate, and same as the lower electrode layer, unnecessary portions are removed to form the dielectric layer with a predetermined shape. Then, a conductor layer that serves as the upper electrode layer is formed on the entire surface, and unnecessary portions are removed to form the upper electrode layer with a predetermined shape. Also, by forming a protective layer and a solder terminal portion, a variable capacitor capable of surface mounting is produced. Such structure and formation method of the capacitance formation portion is also seen in a ferroelectric capacitor formed in part of a semiconductor integrated circuit apparatus.

Such a variable capacitor changes the dielectric constant by applying a direct current bias voltage to the thin film dielectric layer, and as a result the capacitance changes. This change in capacitance also reaches to the high frequency region, and therefore this capacitor can also be used as a variable capacitor in the high frequency region. Using such a change in capacitance of the variable capacitor in the high frequency region, a useful electronic component can be obtained that is capable of changing frequency characteristics by application of direct current bias voltage. For example, in a voltage-controlled thin film resonator in which the above variable capacitor and a thin film inductor are combined, it is possible to change the resonance frequency by application of direct current bias. Also, in a voltage-controlled thin film band-pass filter in which a variable capacitor or a voltage-controlled thin film resonator, a thin film inductor, and a thin film capacitor are combined, it is possible to change the band-pass frequency by application of direct current bias voltage. Also, a variable capacitor can be used in a microwave voltage-controlled electronic component (for example, see Japanese Unexamined Patent Publication JP-A 8-509103 (1996)).

As for the structure of a conventional thin film capacitor, particularly the shape of a stepped portion of the dielectric layer, as shown for example in Fig. 4 of Japanese Unexamined Patent Publication JP-A 8-340090 (1996), a configuration has been adopted in which a side face of the upper electrode layer is positioned to the inside of a side face of the dielectric layer and the side face of the dielectric layer is positioned to the inside of a side face of the lower electrode layer, and a relationship of L ≥ 2D is established between a thickness D of the dielectric layer and a length L of the surface of the dielectric layer which exists between the intersection of the side face of the upper electrode layer with the upper face of the dielectric layer and the intersection of the side face of the dielectric layer with the lower electrode layer. Such a configuration suppresses occurrence of leakage current via the side face of the dielectric body layer, so the leakage current of the capacitor as a whole is greatly reduced, thus enhancing the withstand voltage of the capacitor.

Also, as shown for example in Fig. 14 of Japanese Unexamined Patent Publication JP-A 6-188386 (1994), a stepped portion formed at a part of the dielectric layer has been provided between the intersection of the side face of the upper electrode layer with the upper face of the dielectric layer and the intersection of the side face of the dielectric layer with the lower electrode layer. Such a configuration has less risk that a short circuit will occur between the upper electrode and the lower electrode, and thus increases manufacturing yield. Further, as likewise shown in Fig. 17 of JP-A 6-188386, a stepped portion has been formed by diagonally etching the side face of the dielectric layer so that the side face of the dielectric layer is not separated from the upper electrode layer.

Besides, JP 2006-196871 A1 discloses a thin film capacitor in which for obtaining a high moisture-resistance reliability, at least one of the lower and upper electrode layers has a top lower than a bottom and sides as slopes having streaky, continuous irregularity in a vertical direction. Thereby, the covered insulator layer can be prevented from being peeled from sides of the electrode layers.

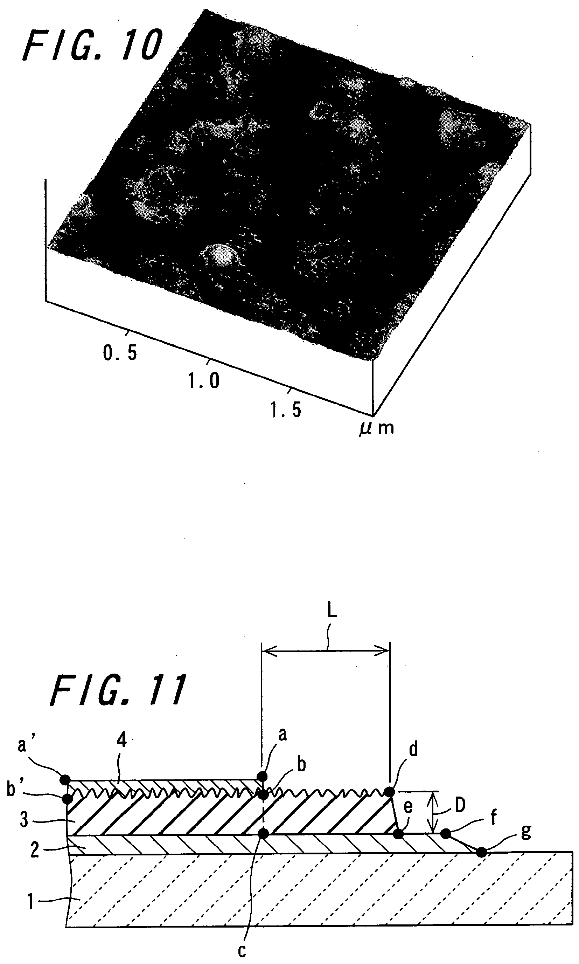

A problem to be solved by the invention is to reduce leakage current and insulation breakdown in the dielectric layer formed between the upper electrode layer and the lower electrode layer. In a variable capacitor, it is necessary to use dielectric material with a high dielectric constant, so growth of a highly crystalline dielectric layer is necessary. When a thin film dielectric layer is formed by a sputtering method or the like, a membrane comprises a grain with a size of about several tens to several hundred nm. Such a grain grows in a columnar shape or in clusters, and the film surface is rough due to irregularities of individual grains. Fig. 11 shows a cross-sectional view exaggerating irregularities of the surface of the dielectric layer where grains are grown. When a highly crystalline dielectric layer has been grown, the grain grows and as a result the dielectric layer has such a rough surface. Here, reference sign 1 denotes a support substrate, reference sign 2 denotes a lower electrode layer, reference sign 3 denotes a dielectric layer, and reference sign 4 denotes an upper electrode layer. In the following drawings as well, the same elements are denoted by the same reference signs. In a case that the upper electrode 4 is on the dielectric layer 3, a side face of the upper electrode layer 4 as shown in Fig. 11 is positioned to the inside of a side face of the dielectric layer 3 and the side face of the dielectric layer 3 is positioned to the inside of a side face of the lower electrode layer 2, and a relationship of L ≥ 2D can be established between a thickness D of the dielectric layer 3 and a length L of the surface of the dielectric layer 3 which exists between the intersection of the side face of the upper electrode layer 4 with the upper face of the dielectric layer 3 and the intersection of the side face of the dielectric layer 3 with the lower electrode layer 2. In this configuration, problems are a leakage current path and withstand voltage. The leakage current path of the film in which grain has been grown mainly occurs at a grain boundary. This is because the crystallinity of the grain boundary is lower than that of the inside of the grain, and leakage current flows easily because impurities and the like have been precipitated. Also, because the grain boundary is in a location of a recessed portion, the grain boundary is in a location where electric field strength is locally strong. Accordingly, when the dielectric layer 3 with a rough surface is given a conventional cross-sectional shape a-b-d-e-f as shown in Fig. 11, the side face of the upper electrode layer 4 cuts across the grain boundary of the dielectric layer 3, and the ground boundary between b-c in Fig. 11 becomes the main leakage current path due to the electric field that concentrates at the end of the upper electrode layer 4, so ultimately the problem of insulation breakdown occurs. This problem becomes prominent particularly in a variable capacitor for a high frequency application, in which direct current and alternating current are applied simultaneously.

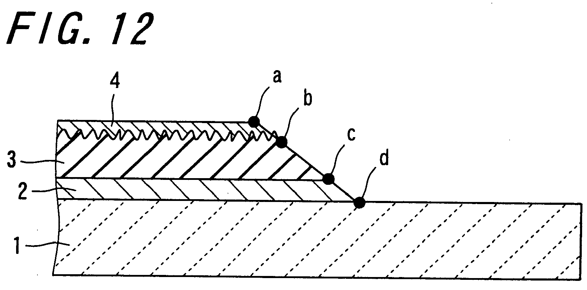

Also, when the film of the upper electrode layer 4 is formed on the dielectric layer 3 with a rough surface, and the upper electrode layer 4 is dry etched using a photolithography step and batch processed using a single mask all the way to the lower electrode layer 2, as indicated by face a-b-c-d in Fig. 12, the side face of the dielectric layer 3 is diagonally etched, and thus it is possible to form a stepped portion in which the side face of the dielectric layer 3 is not separated from the upper electrode layer 4 and the lower electrode layer 2. In this configuration, there is the problem of an electrical short circuit due to redeposition in which deposits re-affix to side face b-c in Fig. 12, which occurs during processing the lower electrode layer 2.

A small leakage current is demanded in order to use a variable capacitor as a constituent component for a filter or a resonator. This is because a variable thin film capacitor is used while steadily applying an external voltage, so even a small amount of leakage current will cause a short circuit of an element or deterioration of dielectric properties. Particularly when the dielectric layer 3 is extremely thin, the leakage current has a tendency to increase, so improvement of the leakage current path has been sought. In particular, leakage current and withstand voltage in the dielectric layer 3 depend on the shapes and the surface roughness of the upper electrode layer 4, the dielectric layer 3 and the lower electrode layer 2.

### Disclosure of Invention

The invention has been devised in view of the problems described above, and it is an object thereof to reduce the leakage current and insulation breakdown in a dielectric layer, and to enhance insulation of a capacitor.

It is a further object of the invention to provide, using the capacitor of the invention, an electronic component such as a highly insulated high frequency voltage-controlled thin film resonator, voltage-controlled thin film high frequency filter, voltage-controlled thin film matching circuit element, voltage-controlled thin film antenna duplexer, or the like.

The above objects are achieved by the features of claims 1 and 7.

According to one of the invention, a capacitor comprises a support substrate, a lower electrode disposed on the support substrate, a dielectric disposed on the lower electrode and having on its upper face a first region and a second region that has lower crystallinity than the first region, and an upper electrode disposed on the first region of the dielectric.

According to one of the invention, the capacitor has the upper face of the dielectric having a first region that is covered with the upper electrode, and having a second region other than the first region, and the second, region has lower crystallinity than the first region, so high dielectric constant is realized in the first region forming capacitance by higher crystallinity, and furthermore, even if an electrical field concentrated at the end of the upper electrode is applied in the second region, the second region has lower crystallinity than the first region, therefore, the grain boundary is unclear, and the path from the upper electrode to the lower electrode via the grain boundary is long, so it is possible to suppress leakage current via the grain boundary, and possible to increase withstand voltage. As a result, it is possible to provide a capacitor that has good insulation.

Also, according to one of the invention, a capacitor comprises a support substrate, a lower electrode disposed on the support substrate, a dielectric disposed on the lower electrode and having on its upper face a first region and a second region that has lower surface roughness than the first region, and an upper electrode disposed on the first region of the dielectric.

According to one of the invention, since the capacitor has the surface roughness of the second region lower than the surface roughness of the first region, the side face of the upper electrode does not cut across the rough surface even in a case that the surface of the dielectric layer is rough by growing the dielectric layer with high crystallinity in order to obtain high dielectric constant, and furthermore since the electric field concentrated at the end of the upper electrode is not applied in a recessed portion of the dielectric film, it is possible to suppress the generation of leakage current in the second region of the dielectric, thus increasing withstand voltage, and as a result it is possible to provide a capacitor that has good insulation.

Also, in one of the invention, it is preferable that the dielectric is a perovskite oxide crystal containing Ba, Sr, and Ti.

According to one of the invention, when the dielectric is a perovskite oxide crystal containing Ba, Sr, and Ti, it is possible for the dielectric to have high dielectric constant.

Also, in one of the invention, it is preferable that in the dielectric, a surface roughness of the first region is greater than a surface roughness of the second region.

According to one of the invention, in a case that in the dielectric has the surface roughness of the first region greater than the surface roughness of the second region, the electric field concentrated at the end of the upper electrode is not applied in a recessed portion of the dielectric film, therefore, it is possible to suppress the generation of leakage current in the second region of the dielectric, thus increasing withstand voltage, and as a result it is possible to provide a capacitor that has good insulation.

Also, in one of the invention, it is preferable that the dielectric has a stepped portion where a thickness in the second region is smaller than that of the first region.

According to one of the invention, in a case that the dielectric has a stepped portion where the thickness in the second region is smaller than the thickness of the first region, since it is possible to lengthen the path of leakage current from the side face of the upper electrode through the surface of the dielectric and arriving at the lower electrode, it is possible to increase withstand voltage, and as a result it is possible to provide a capacitor that has good insulation.

Also, in one of the invention, it is preferable that the second region is provided so as to surround a periphery of the first region.

According to one of the invention, in a case that the second region is provided so as to surround the periphery of the first region, since the second region which reduces leakage current is at the entire edge of the upper electrode where the electrical field concentrates, and it is possible to provide a capacitor that has excellent insulation.

Also, in one of the invention, it is preferable that in the dielectric, the second region contains more amount of Ar than the first region.

According to one of the invention, since the dielectric layer has the second region containing more amount of Ar than the first region, crystallinity of the dielectric layer is reduced in the second region, and thus the boundary between grains that have grown also is unclear. Whereby, the path of leakage current via the grain boundary in the dielectric layer is blocked, so leakage current that is generated in the dielectric layer is further reduced, thus increasing withstand voltage. As a result, it is possible to provide a capacitor that has good insulation.

Also, in one of the invention, it is preferable that an insulating material that has lower dielectric constant than the dielectric is further provided on the second region of the dielectric.

According to one of the invention, in a case that an insulating material having lower dielectric constant than the dielectric is further provided on the second region of the dielectric, it is possible to reduce the generation of parasitic capacitance.

Also, according to one of the invention, a high frequency component comprises a circuit substrate on which a conductor is formed, and the capacitor mentioned above whose the upper electrode and the lower electrode are connected to the conductor.

According to one of the invention, since the high frequency component includes a circuit substrate on which a conductor is formed, and the capacitor mentioned above whose the upper electrode and the lower electrode are connected to the conductor by using a capacitor having good insulation, it is possible to realize a desired capacitance, and possible for the high frequency component to have stable properties.

### Brief Description of Drawings

Other and further objects, features, and advantages of the invention is more explicit from the following detailed description taken with reference to the drawings wherein:
Fig. 1 is a cross-sectional view that schematically shows a capacitor according to a first embodiment of the invention;
Fig. 2 is a cross-sectional view that schematically shows the capacitance formation portion of the capacitor according to the first embodiment of the invention;
Fig. 3 is a cross-sectional view for explaining a cross-sectional configuration according to a second embodiment of the invention, and a first and a second region;
Fig. 4 is a perspective view that schematically shows the layer structure of the capacitor according to one of the invention;
Fig. 5 is a cross-sectional view taken along line A-A' in Fig. 4, schematically showing a surface state and a stepped portion of the capacitor according to one of the invention;
Figs. 6A and 6B are respectively a plan view and a cross-sectional view of a high frequency component according to one of the invention;
Fig. 7 is results that XPS analysis was performed with respect to the amount of Ar ions included in a dielectric layer of the capacitor according to one of the invention;
Fig. 8 is an image of the surface roughness of a dielectric in the first region of the capacitor according to one of the invention;
Fig. 9 is an image of the surface roughness of a dielectric during processing in the second region of the capacitor according to one of the invention;
Fig. 10 is an image of the surface roughness of a dielectric after forming the second region of the capacitor according to one of the invention:
Fig. 11 is a cross-sectional view that schematically shows a surface state and a stepped portion of a conventional capacitor; and
Fig. 12 is another cross-sectional view that schematically shows a surface state and a stepped portion of a conventional capacitor.

### Best Mode for Carrying out the Invention

Now referring to the drawings, preferred embodiments of the invention are described below.

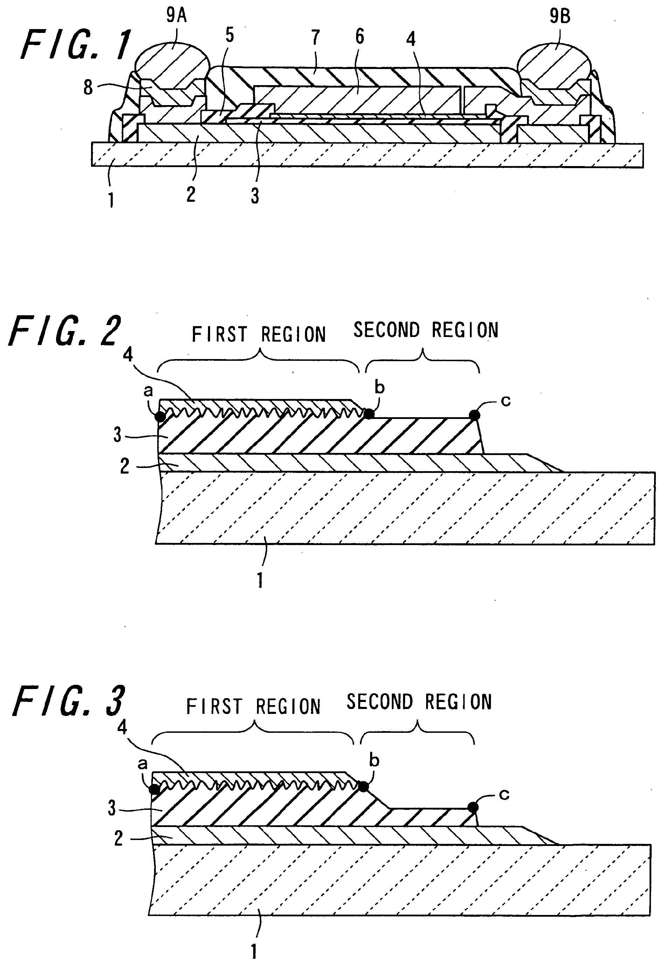

Embodiments of the invention are described below with reference to the accompanying drawings. In Fig. 1, reference sign 1 denotes a support substrate, reference sign 2 denotes a lower electrode layer serving as a lower electrode, reference sign 3 denotes a dielectric layer serving as a dielectric, reference sign 4 denotes an upper electrode layer serving as an upper electrode, reference sign 5 denotes an insulating layer serving as an insulating material, reference sign 6 denotes a extracting electrode layer, reference sign 7 denotes a protective layer, reference sign 8 denotes a solder diffusion prevention layer, and reference signs 9A and 9B denote solder terminals. In the drawings below, same elements are denoted by the same reference signs, and duplicate descriptions are omitted.

A capacitance formation region (capacitance formation portion) is an opposing portion where the dielectric layer 3 is sandwiched between the lower electrode layer 2 and the upper electrode layer 4. The capacitance formation portion is described using Fig. 2 which shows the cross-sectional structure and an exaggerated view of the surface state of the capacitance formation portion. In Fig. 2, reference sign 1 denotes the support substrate, reference sign 2 denotes the lower electrode layer, reference sign 3 denotes the dielectric layer, and reference sign 4 denotes the upper electrode layer. A first region corresponds to an a-b region of the dielectric layer 3 that is covered with the upper electrode layer 4. A second region corresponds to a b-c region of the dielectric layer 3 that is not covered with the upper electrode layer 4. Such structure of the capacitance formation region using a high dielectric constant thin film is not limited to variable capacitance elements, and is also applicable to thin film capacitors such as decoupling capacitors and DRAM.

It is an object of the invention to reduce leakage current and insulation breakdown in the dielectric layer that occurs due to surface roughness caused by crystallinity of the dielectric layer, and to enhance insulation of the capacitor.

A first embodiment of the invention is described with reference to Figs. 1 and 2.

Fig. 2 shows an enlarged view of relevant portions of the capacitance formation portion of the capacitor according to one of the invention. In Fig. 2, the first region (a-b region) of the dielectric layer 3 has greater crystallinity than the second region (b-c region). More specifically, by increasing the crystallinity of the first region forming capacitance, it is possible for the dielectric to have high dielectric constant, and possible to increase performance as a capacitor. On the other hand, by making crystallinity low in the second region, which is not involved in capacitance formation, it is possible to be less likely to generate leakage current via the grain boundary. Particularly when an amorphous state has been established, there is no longer a clear grain boundary, and recessed portions which is origin of leakage current are eliminated, so such a state is preferable. Also, because crystallinity of the second region is poor, dielectric constant is low, so it is possible to be less likely to generate parasitic capacitance. Note that the first region and the second region correspond to upper faces of the dielectric layer 3, and it is not necessary to establish the above relationship throughout the entire thickness direction of the dielectric layer 3.

Recently, with advancements in the reduction of the size and profile of capacitors, low voltage driving is demanded, so the thickness of the dielectric layer 3 also has been smaller. Therefore, when the dielectric layer 3 has good crystallinity, the dielectric layer 3 may be configured with only one columnar crystal grain in the thickness direction. In the case of such a configuration, the leakage current via the grain boundary has an even greater effect. Consequently, in order to enhance insulation of the capacitor, it is effective to make crystallinity low in the upper face (the second region) of the dielectric layer 3 that contacts the side face of the upper electrode layer 4 where the electric field concentrates, and to reduce the generation of leakage current via the grain boundary.

Here, high crystallinity means that the ratio of singlecrystallization per unit area is high. In theory, since single crystals has the crystal lattices aligned at a fixed interval, the region where the crystal lattices are aligned at a fixed interval in the first region of this embodiment is larger than the region where the crystal lattices are aligned at a fixed interval in the second region. Further, it is desirable that the crystal lattices are aligned in a particular fixed crystal orientation. In an actual device it is possible to judge that crystallinity is high in a case that the size of crystal grains in the first region is larger than the size of crystal grains in the second region. Alternatively, it is possible to judge that crystallinity is high in a case that the presence of crystal grains cannot be confirmed in the second region which is in an amorphous state whereas the presence of crystal grains is confirmed in the first region.

As methods for making crystallinity of the second region lower than crystallinity of the first region in this way, there is a method in which for example, after forming the dielectric layer 3, the surface of the dielectric layer 3 is modified, a method in which the surface state of the lower electrode layer 2 serving as the underlayer of the dielectric layer 3 is modified and the crystallinity of the dielectric layer 3 formed on that surface is changed, and the like. In a case where the surface of the dielectric layer 3 is modified, the surface may be treated by irradiating plasma or ions at the appropriate location. More specifically, after production so as to have the same crystallinity as the first region throughout the entire surface of the dielectric 3, with an ECR (Electron Cyclotron Resonance) apparatus or the like, damage is given from the upper face in a region other than in the first region (which is the second region), thus establishing an amorphous state and smoothing irregularities of the surface that are caused by crystallinity. In this way it is possible to make crystallinity low in the second region. Further, when modification is performed from the side of the lower electrode layer 2, the lower electrode layer 2 may be irradiated with the same plasma or ions at the appropriate location. It is possible to grow a dielectric layer 3 having high-crystallinity in a smooth-surfaced portion of the lower electrode layer 2, and possible to grow a dielectric layer 3 having low-crystallinity in a portion other than that smooth-surfaced portion.

Next, each element is described in detail.

### <Support substrate>

A support substrate 1 may include Al₂O₃, SiO₂/Si, MgO, LaAlO₃, SrTiO₃, and the like, and preferably may have adequate flatness and surface roughness, which does not particularly limit the materials thereof, provided that the layer (substrate) directly below the lower electrode layer 2 has insulating properties.

### <Lower electrode layer>

The lower electrode layer 2 is formed on the support substrate 1. The conductor material of the lower electrode layer 2 may include, when using a metal with a low coefficient of resistance for a high Q, copper, aluminum, gold, silver, or the like. Also, from the viewpoint of reduction resistance of an oxide dielectric thin film, the conductor material may include IrO₂/Ir, SrRuO₃, or the like, which are oxide conductors. Whatever material is used, it is necessary to take care that the problem of increased leakage current does not occur due to diffusion to or reaction with the high-dielectric constant thin film dielectric layer 3 since a high temperature thermal history is brought in the course of forming the high-dielectric constant dielectric layer 3 on that material. Therefore, it is preferable that Pt, which is a material having a high melting point, is used. It is necessary to set the film thickness such that there is not increased loss due to frequency or electrodes with the high-resistance material. These are manufactured by a vapor synthesis method such as a sputtering method or a vacuum depositing method, and processed in a photolithography step and a dry etching step.

### <Dielectric layer>

The material of the dielectric layer 3 preferably has high dielectric constant, and furthermore, may include a dielectric material whose dielectric constant can change greatly due to externally applied voltage, i.e., perovskite oxide such as BaTiO₃, SrTiO₃, (Ba, Sr) TiO₃, or the like, which is particularly preferable when a perovskite crystal contains Bi, Sr, and Ti since the material can have high dielectric constant. These can be formed by a thin film manufacturing method such as a solution method such as a sol-gel method, or a vapor synthesis method such as a sputtering method or a laser ablation method. In the capacitor, since it is necessary to use dielectric material with a high dielectric constant, a highly crystalline dielectric film has to be grown. Therefore, a high film growth temperature or high temperature annealing after film growth is required. Also, flattening the lower electrode layer 2 that serves as the underlayer makes it possible to form a highly crystalline dielectric film. For this purpose, it is effective to hold the substrate for a fixed time at a high temperature for forming the dielectric layer 3 after forming the lower electrode layer 2. Also, in order to change the crystallinity of the first region and the second region of the dielectric layer 3, plasma or ion irradiation of only the first region of the lower electrode layer 2 may be performed to flatten the surface. When the dielectric layer 3 is formed by a sputtering method or the like, a membrane includes grains with a size of about several tens to several hundred nm. Such a grain grows in a columnar shape or in clusters, and the film surface is rough due to irregularities of individual grains. Fig. 2 shows an exaggerated view of the surface of a dielectric layer whose surface has irregularities due to growing grain in the first region. When a highly crystalline dielectric film has been grown, the grain grows to be the dielectric layer with such a rough surface. The dielectric layer 3, for example, is formed so as to cover the surface of the lower electrode layer 2, and afterward is removed by wet etching or dry etching except in a capacitance generating region. The thinner the film thickness of a high dielectric constant thin film (the dielectric layer 3) is, the more electric field strength increases, which gives an advantage of being able to obtain a higher capacitance change ratio. On the other hand, in a case that the film is thinner, since the problems that leakage current increases and the effective relative dielectric constant decreases occurs, it is necessary to set an appropriate film thickness.

Particularly when a perovskite crystal containing Bi, Sr, and Ti is used as the dielectric layer 3, a columnar crystal often grows. Therefore, when a large columnar crystal having good crystallinity grows, a path of the grain boundary in which leakage current flows is short. In the case of such a configuration, the invention particularly makes it possible to reduce the generation of leakage current. Note that the first region and the second region of the dielectric layer 3 is ordinarily made of the same material.

### <Upper electrode layer>

A metal such as Au, Cu, Ag, or Pt, a conductive oxide such as IrO₂ or RuO₂, or the like is used for the upper electrode layer 4, in consideration of electrode resistance and adhesion, reduction resistance, and the like. If the lower electrode layer 2 and the dielectric layer 3 as well as the upper electrode layer 4 are formed in the same batch without exposure to air, then it is possible to prevent excess attachment of foreign matter, oil, or the like at each interface, thus adhesion improves, intrusion of moisture and the like can be prevented, therefore, moisture resistance can be greatly enhanced, and stable properties can be produced.

### <Insulating layer>

The insulating layer 5 is formed to cover all of the structure of the upper electrode layer 4, the dielectric layer 3 and the lower electrode layer 2, and the insulating layer 5 is necessary for insulation of the upper electrode layer 4 and the lower electrode layer 2, and the smaller parasitic capacitance generated therebetween. Therefore, it is particularly necessary to cover the second region of the dielectric layer 3. As the material of the insulating layer 5, it is preferable to use an organic material such as BCB (benzocyclobutene) or polyimide, inorganic material such as SiO₂ or Si₃N₄, and it is preferable that the material of the insulating layer 5 has a lower dielectric constant than the material of the dielectric layer 3 in order to have high insulation and smaller parasitic capacitance. It is preferable that a CVD method which can make a comparatively uniform thickness film on the three-dimensional and compricated shaped underlayer be used for the forming method of the above-described layers. Dry etching using a photoresist as a mask is performed to form an opening portion directly above the upper electrode layer 4. At the same time, an opening portion which exposes part of the lower electrode layer 2 to the upper face of the capacitor is formed.

### <Extracting electrode layer>

Next, the extracting electrode 6 is formed. The extracting electrode 6 connects one terminal to the upper electrode layer 4, and provides a path from the upper electrode to the one terminal. It is desirable to use a metal having low resistance, such as Au or Cu, as the material of the extracting electrode 6. In consideration of adhesion with the insulating layer 5, an adhesion layer of Ti, Ni, or the like may be used, within a range that the resistance of the upper electrode layer 4 is not greatly increased.

### <Protective layer>

Next, the protective layer 7 is formed. In order to form a terminal that is electrically connected to the lower electrode layer 2 and a terminal that is electrically connected to the upper electrode layer 4, the protective layer 7 is formed such that a part of the layer is exposed,. The protective layer 7 mechanically protects elements from the outside, and in addition, protects against deterioration of element material due to moisture or a chemical reaction with oxygen, contamination due to attachment of dust or foreign matter, deterioration due to damage during mounting, contamination by chemicals or the like, oxidation, etc. As for the material of the protective layer 7, a material with high heat resistance and excellent ability to cover steps may be used, and it is necessary to adopt a material that does not excite vibrations unnecessarily. Specifically, it is possible to use organic thermosetting or light-curing material, such as polyimide or BCB resin.

### <Terminals>

The solder diffusion prevention layer 8 is formed in order to prevent solder from diffusing to electrodes when reflowing to form the solder terminals 9A and 9B or mounting. Ni is suitable for the material of the solder diffusion prevention layer 8. Also, in some cases, about 0.1 µm of Au, Cu, or the like that has high solder wettability may be formed on the surface of the solder diffusion prevention layer 8 in order to enhance solder wettability. Finally, the solder terminals 9A and 9B are formed. These are formed to facilitate mounting process. The solder terminals 9A and 9B are formed by performing reflow after printing solder paste.

### <Patterning of each layer>

Patterning of the lower electrode layer 2, the dielectric 3, and the upper electrode layer 4 is performed by applying a photoresist, then performing a process of patterning in a predetermined shape the photoresist layer formed by a photolithography technique, and then performing a dry etching process using an ECR apparatus or the like. In this case, by controlling the etching conditions in ECR etching, in particular the Ar gas flow rate and etching gas pressure, and the acceleration voltage of Ar ions, it is possible to control the shape of the side faces of the lower electrode layer 2, the dielectric layer 3, and the upper electrode layer 4, and the crystallinity of the upper face of each layer. For example, when patterning is performed in order from the layer positioned above after layering up to the upper electrode layer 4, a step of irradiating the exposed portion of the dielectric layer 3 with Ar ions, using the photoresist layer used during pattern formation of the upper electrode layer 4, to modify its surface state may be added between the steps of patterning of the upper electrode layer 4 and patterning of the dielectric layer 3, .

Due to etching such that the second region includes more amount of Ar ions than the first region, crystallinity of the second region decreases, and the grain boundary becomes unclear. Therefore, leakage current from the end of the upper electrode layer 4 to the grain boundary or a recessed portion of the surface is less likely to occure, and thus insulation breakdown in the dielectric layer 3 can be reduced. This effect becomes prominent particularly in a variable capacitor for a high frequency application, in which direct current and alternating current are applied simultaneously.

In the manner described above, it is possible to form the capacitor shown in Fig. 1.

Next a capacitor according to another embodiment of the invention is described.

Fig. 3 shows an enlarged view of relevant portions of the capacitance formation portion of the capacitor according to a second embodiment of the invention. In the capacitor shown in Fig. 2, attention is paid to the difference in crystallinity between the first region and the second region, but in the capacitor shown in Fig. 3, attention is paid to the fact that surface roughness (arithmetic mean roughness) is different between the first region and the second region. Following is a description of only the points that differ from Fig. 2.

In Fig. 3, the arithmetic mean roughness is greater in the first region of the dielectric layer 3 than in the second region. The arithmetic mean roughness of the upper face of the dielectric layer 3 is correlated with the size (grain size) of the crystal grains that constitute the dielectric layer 3. That is, since the first region forming capacitance has not only growing high-dielectric constant crystal grains, but also the larger size grains, there are fewer grain boundaries with low dielectric constant, and it is possible to have a high-dielectric constant dielectric, and therefore it is possible to improve a capacitor in quality. On the other hand, in the second region which does not form capacitance, the above arithmetic mean roughness is preferable since the smaller arithmetic mean roughness reduce the number of recessed portions which may be an origin of leakage current.

Also, in a case that the second region includes the aggregated crystals with a small grain size or is in an amorphous state so that the second region has the small arithmetic mean roughness, dielectric constant is low dut to poor crystallinity, and therefore it is possible to be less likely to generate parasitic capacitance. Furthermore, since the grain size is small, the path of leakage current via the grain boundary is longer and more complicated in comparison to a case in which the second region includes only one crystal grain in the thickness direction, and thus it is possible to be less likely to generate leakage current via the grain boundary.

In order to make the arithmetic mean roughness less in the second region than in the first region, the second region may be irradiated with plasma or ions from the upper face of the dielectric layer 3.

Also, as shown in Fig. 3, the dielectric layer 3 may have a stepped portion where the thickness in the second region is smaller than the thickness in the first region. Fig. 3 shows an example in which the entire second region is the stepped portion. Since the stepped portion makes it possible to lengthen the distance from the end of the upper electrode layer 4 where the electric field concentrates to the lower electrode layer 2 via the upper face and the side face of the dielectric layer 3, the generation of leakage current can be reduced.

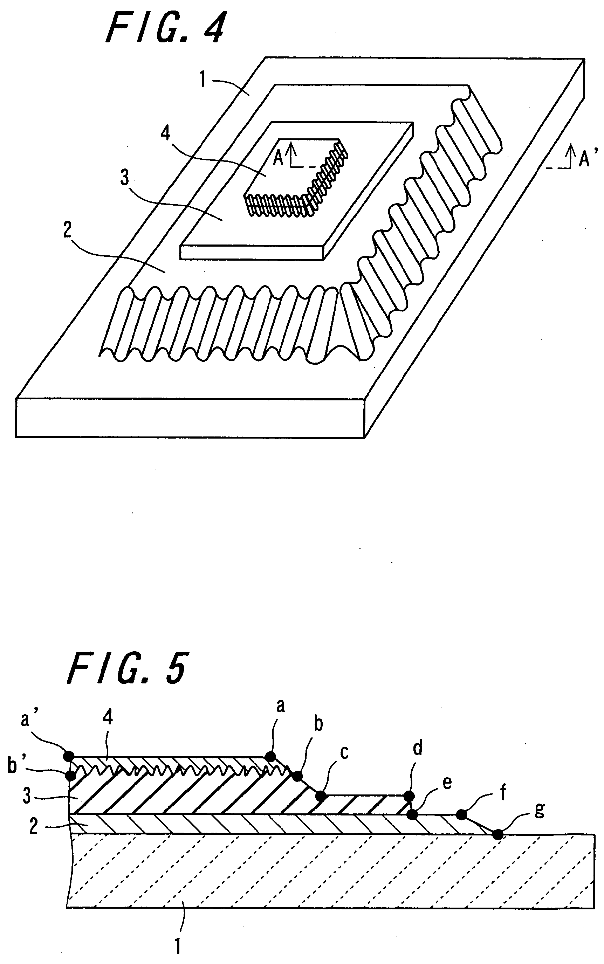

The following configuration may be adopted in order to form such a stepped portion. This configuration is described with reference to Figs. 4 and 5. Fig. 4 is a perspective view that schematically shows the layer structure of the capacitor according to one of the invention, and Fig. 5 is a cross-sectional view taken along line A-A' in Fig. 4, schematically showing relevant portions of the capacitance formation portion.

During patterning of the lower electrode layer 2, the dielectric 3, and the upper electrode layer 4, by controlling the etching conditions in ECR etching, in particular the Ar gas flow rate and etching gas pressure, and the acceleration voltage of Ar ions, it is possible to control the shape and surface roughness of the side faces of the lower electrode layer 2, the dielectric layer 3, and the upper electrode layer 4.

In dry etching of the upper electrode layer 4, by processing to a part of the dielectric layer 3, it is possible to have a cross-sectional configuration (a-b-c-d in Fig. 5) in which a stepped portion is formed at a part of the dielectric layer 3 between the intersection of the side face of the upper electrode layer 4 with the upper face of the dielectric layer 3 and the intersection of the side face of the dielectric layer 3 with the lower electrode layer 2. Further, by executing a photolithography step on the dielectric layer 3 using another mask, it is possible to form the stepped portion c-d-e-f in Fig. 5. Under the etching conditions at this time, surface roughness of the face b-c-d is set to be smaller and the end of the upper electrode layer 4 is set not to cut across a recessed portion of the dielectric layer 3.

It is possible to form the stepped portion in the manner described above.

Such a stepped portion may be provided in the first embodiment shown in Fig. 2. Also, in the example shown in Fig. 3, although an example was described in which the entire second region was made the stepped portion, the stepped portion may be only part of the second region. Furthermore, in the above-described first and second embodiments, it is preferable that, as shown in Fig. 4, the second region is formed so as to surround the periphery of the first region. This configuration makes it possible to be less likely to generate leakage current throughout the periphery of the end of the upper electrode layer 4 where the electric field concentrates, and thus it is possible to provide a capacitor with a high level of insulation.

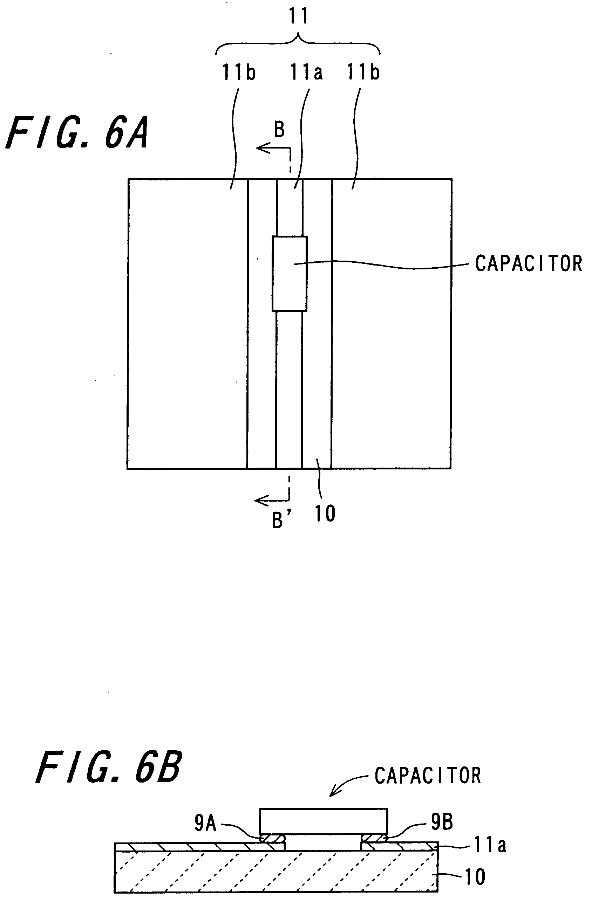

Next, a high frequency component according to one of the invention is described. Fig. 6A shows a schematic plan view of a high frequency component according to one of the invention, and Fig. 6B shows a cross-sectional view taken along line B-B' in Fig. 6A.

In Figs. 6A and 6B, reference sign 10 denotes a circuit substrate, and reference sign 11 denotes a conductor formed on the circuit substrate 10. The conductor 11 includes a signal conductor 11a, and a pair of ground conductors 11b which are disposed on both ends of the signal conductor 11a and are separated from each other, the signal conductor 11a and round conductors 11b constituting a coplanar path. The signal conductor 11a has a non-continuous portion that is interrupted midway, and the solder terminals 9A and 9B of the capacitor according to one of the invention shown in Fig. 1 are connected to the signal conductor 11a so that this non-continuous portion becomes continuous. By connecting the solder terminals 9A and 9B to the signal conductor 11a in this manner, the lower electrode layer 2 and the upper electrode layer 4 of the capacitor are electrically connected to the signal conductor 11a, and thus the capacitor functions as an electronic component that constitutes a high frequency circuit. For example, as shown in Figs. 6A and 6B, it is possible to configure a high frequency component that forms a resonator circuit from an inductor component formed by the conductor 11, and the capacitor according to one of the invention. Such a high frequency component can be provided with high reliability and a stable resonance frequency, i.e., stable characteristics since insulation of the capacitor according to one of the invention is excellent.

Here, for example, it is possible to use a ceramic multilayer circuit board including alumina or the like as the circuit substrate 10. The material of the conductor 11 is not particularly limited as long as the material is conductive.

### EXAMPLES

Next, a more specific example of the invention is described.

First, using an R-plane sapphire substrate as the support substrate 1, a film of Pt used as the material of the lower electrode layer 2 is formed on the support substrate 1 by a sputtering method with the substrate temperature at about 700°C. For the thin film dielectric layer 3, a film with a thickness of 200 nm is formed by a sputtering method with the substrate temperature at about 800°C, using a target comprised of (Ba_{0.5}Sr_{0.5})TiO₃. On this dielectric layer 3, a film of the upper electrode layer 4 comprised of Au is formed by a sputtering method. These are formed in order within the same chamber, without exposure to air.

Next, a photoresist is applied, then a photoresist layer formed by a photolithography technique is patterned to be in a predetermined shape, and then the upper electrode layer 4, the dielectric layer 3, and the lower electrode layer 2 are etched in order in a predetermined shape using an ECR apparatus. Here, as conditions for ECR etching, an Ar gas flow rate of 20 sccm, an etching gas pressure of 1 Pa, and an Ar ion acceleration voltage of 0.3 kV were used. During dry etching of the upper electrode layer 4, by processing up to the midst of the dielectric layer 3 after patterning of the upper electrode layer 4, a cross-sectional shape (a-b-c-d in Fig. 5) as shown in Fig. 3 was produced to have a stepped portion at a portion of the dielectric body between the intersection of the side face of the upper electrode layer 4 with the upper face of the dielectric layer 3 and the intersection of the side face of the dielectric layer 3 with the lower electrode layer 2. Furthermore, by executing a photolithography step on the dielectric layer 3 using another mask, the stepped portion c-d-e-f in Fig. 5 was formed. At this time, the surface roughness of the face b-c-d in the second region became smaller, and the end of the upper electrode layer 4 was set not to cut across a recessed portion of the dielectric layer, so it was possible to ultimately form the cross-sectional shape of the lower electrode layer 2, the dielectric 3, and the upper electrode layer 4 as shown in Fig. 3.

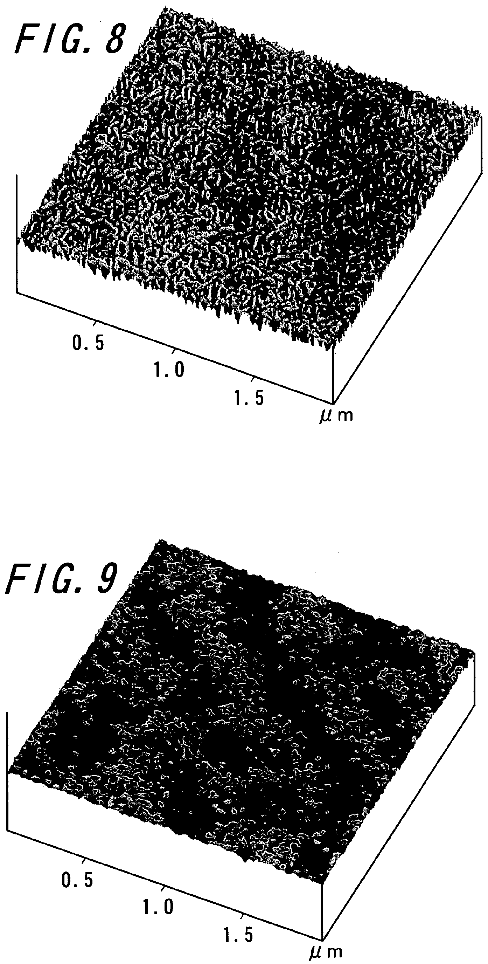

The each surface roughness of the first and second regions in this example was investigated. The surface roughness of the first region, which means the roughness of the surface of a BST film (the dielectric layer 3) when the Au constitutes the upper electrode layer 4 has been peeled away, was 1.83 nm. The surface roughness Ra of the dielectric 3 (the second region in Fig. 3) not covered with the upper electrode layer 4 was 0.25 nm, and therefore it was possible to obtain a surface roughness smaller than in the first region. Also, the surface roughness Ra of the dielectric layer 3 during processing in which the dielectric layer 3 not covered with the upper electrode layer 4 is processed to the second region was 0.36 nm. Therefore, it was confirmed that surface roughness could be smaller by advancing the ECR etching process. The surface roughness values were measured by AFM (Atomic Force Microscope: Digital Instruments Co., Dimension 3000). Also, the first and second regions and the upper face of the dielectric layer 3 during processing were observed by AFM to confirm the state of the grain boundary. AFM images in the first and second regions are shown in Figs. 8 and 10, respectively. Also, the AFM image of the dielectric layer 3 during processing to the second region is shown in Fig. 9. From these drawings, it was confirmed that the grain boundary was less clear in the second region than in the first region. Also, since undulation of crystal grains, which could be confirmed in the first region, could not be confirmed in the second region, it was inferred that crystallinity was lower in the second region than in the first region. Furthermore, it was confirmed that the grain boundary became more unclear by advancing the processing.

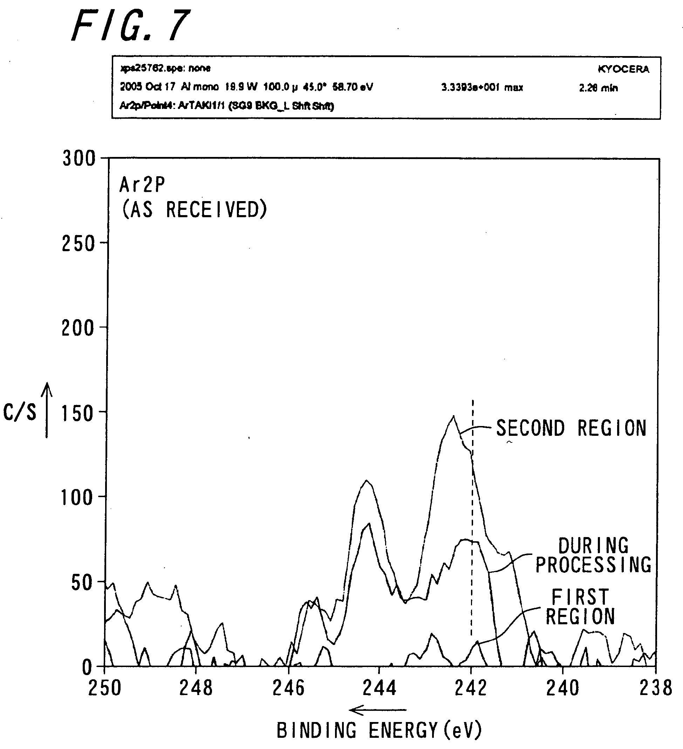

Next, XPS (X-ray Photo-electron Spectroscopy: Quantum 2000 made by Ulvac-Phi, Inc.) analysis was performed on the BST film (dielectric layer 3) surface with respect to the amount of Ar ions included in the dielectric layer 3. Fig. 7 shows the results of that analysis. The Ar2p peak with a narrow spectrum is at 242 eV. When comparing the amount of Ar included in the second region and the first region, it was confirmed from that peak strength that a greater amount of Ar were included in the second region. By processing the surface of the dielectric layer 3 with the ECR apparatus in this manner, it was possible to perform etching such that the second region included a greater amount of Ar ions than the first region.

Next, an SiO₂ film was formed as the insulating layer 5 using a CVD apparatus employing TEOS (tetraethoxysilane) gas as raw material. After processing a photoresist layer on that film, etching in a predetermined shape was performed using RIE.

Next, a film was formed as the extracting electrode layer 6 by layering Ni and Au in order using a sputtering method, and patterned to be in a predetermined shape.

Finally, the protective layer 7, the solder diffusion prevention layer 8, and the solder terminals 9A and 9B were formed in order. Polyimide resin was used in the protective layer 7, and Ni was used in the solder diffusion prevention layer 8.

In the capacitor according to one of the invention, which was obtained in this manner, as a result of observation of the side face shape of the lower electrode layer 2 and the upper electrode layer 4 with a cross-section SEM (Scanning Electron Microscopy), it was confirmed that the upper face was smaller than the lower face for each layer, and that the BST film thickness of the second region not covered with the upper electrode layer 4 had a stepped portion thinner than the first region covered with the upper electrode layer 4.

Therefore, leakage current from the end of the upper electrode to the grain boundary or a recessed portion of the surface was less likely to occur, and insulation breakdown in the dielectric stepped portion could be reduced. It is thought that this effect became prominent particularly in a variable capacitor for a high frequency application, in which direct current and alternating current are applied simultaneously.

Also, when insulation of a conventional thin-film capacitor with a stepped structure as shown in Figs. 11 and 12 was evaluated, much insulation breakdown was observed in the dielectric stepped portion, as a result the advantage of the invention could be confirmed.

Note that in the above example, the crystallinity and surface roughness of the first and second regions of the dielectric layer 3 were measured from the upper face (surface) of the dielectric layer 3 using- AFM, but as for crystallinity, half widths may be measured using thin film X-ray diffraction, and those half widths then compared.

Also, when there is a concern that the surface state of the dielectric layer 3 will change due to peeling away the upper electrode layer 4, measurement may be performed by observing the cross-section of the capacitor, and performing TEM (transmission electron microscopy), electron diffraction, and reflection electron diffraction. For example, when performing measurement using TEM observation, the size (average crystal size) of crystal grain may be confirmed, or presence of an amorphous state in the second region may be confirmed. In the case of performing measurement using electron diffraction or reflection electron diffraction, the state of the crystal, such as a singlecrystal, polycrystal, or amorphous state, or the ratio thereof, may be judged from the diffraction pattern. In this case, for example, a cross-section along line A-A' in Fig. 4 may be produced with a microtome, an FIB (focused ion beam), or the like. Cross-sections may also be produced separately for the first region and the second region. Furthermore, the location of measurements is not particularly limited as long as in the first region and the second region, but it is favorable to use positions separated from the end of the upper electrode layer 4 by the same distance when viewed from above.

The invention may be embodied in other specific forms with the scope of the invention being indicated by the appended claims rather than by the foregoing description and all changes which come within the meaning of the claims are therefore intended to be embraced therein.

## Claims

1. A capacitor comprising:
a support substrate (1);
a lower electrode (2) disposed on the support substrate (1);
a dielectric (3) disposed on the lower electrode (2); and
an upper electrode (4) disposed on the dielectric (3),
wherein an upper face of the dielectric (3) comprises a first region (a-b) that is covered with the upper electrode (4) and a second region (b-c) that is a region except the first region,
**characterised in that**
the first region (a-b) of the dielectric has a higher crystallinity than that of the second region (b-c), and
a surface roughness of said first region (a-b) is greater than that of said second region (b-c).

2. The capacitor of claim 1, wherein the dielectric (3) is a perovskite oxide crystal containing Ba, Sr, and Ti.

3. The capacitor of claim 1, wherein the dielectric has a stepped portion where a thickness of the second region is smaller than that of the first region.

4. The capacitor of claim 1, wherein the second region is provided so as to surround a periphery of the first region.

5. The capacitor of claim 1, wherein in the dielectric, the second region contains more amount of Ar than the first region.

6. The capacitor of claim 1, further comprising an insulating material (5) provided on the second region of the dielectric and having lower dielectric constant than the dielectric.

7. A high frequency component comprising:
a circuit substrate on which a conductor is formed; and
the capacitor of claim 1 whose the upper electrode and the lower electrode are connected to the conductor.

## Patentansprüche

1. Ein Kondensator aufweisend:
ein Trägersubstrat (1);
eine untere Elektrode (2), welche auf dem Trägersubstrat (1) angeordnet ist;
ein Dielektrikum (3), welches auf der unteren Elektrode (2) angeordnet ist; und
eine obere Elektrode (4), welche auf dem Dielektrikum (3) angeordnet ist,
wobei eine obere Fläche des Dielektrikums (3) einen ersten Bereich (a-b), der mit der oberen Elektrode (4) bedeckt ist, und einen zweiten Bereich (b-c) aufweist, der ein Bereich mit Ausnahme des ersten Bereichs ist,
**dadurch gekennzeichnet, dass**
der erste Bereich (a-b) des Dielektrikums eine höhere Kristallinität hat als der zweite Bereich (b-c), und eine Oberflächenrauheit des ersten Bereichs (a-b) größer ist als die des zweiten Bereichs (b-c).

2. Der Kondensator gemäß Anspruch 1, wobei das Dielektrikum (3) ein Perowskit-Oxid-Kristall ist, der Ba, Sr und Ti enthält.

3. Der Kondensator gemäß Anspruch 1, wobei das Dielektrikum einen abgestuften Abschnitt hat, wo eine Dicke des zweiten Bereichs geringer ist als die des ersten Bereichs.

4. Der Kondensator gemäß Anspruch 1, wobei der zweite Bereich bereitgestellt ist, sodass er einen Umfang des ersten Bereichs umgibt.

5. Der Kondensator gemäß Anspruch 1, wobei in dem Dielektrikum der zweite Bereich eine größere Menge an Ar enthält als der erste Bereich.

6. Der Kondensator gemäß Anspruch 1, ferner aufweisend ein Isoliermaterial (5), das an dem zweiten Bereich des Dielektrikums bereitgestellt ist und eine geringere Dielektrizitätskonstante hat als das Dielektrikum.

7. Eine Hochfrequenzkomponente aufweisend:
ein Schaltungssubstrat, auf welchem ein Leiter gebildet ist; und
den Kondensator gemäß Anspruch 1, dessen obere Elektrode und untere Elektrode mit dem Leiter verbunden sind.

## Revendications

1. Condensateur comprenant :
un substrat de support (1) ;
une électrode inférieure (2) disposée sur le substrat de support (1) ;
un diélectrique (3) disposé sur l'électrode inférieure (2) ; et
une électrode supérieure (4) disposée sur le diélectrique (3),
une face supérieure du diélectrique (3) comprenant une première région (a-b) qui est recouverte par l'électrode supérieure (4) et une deuxième région (b-c) qui est une région excluant la première région,
**caractérisé en ce que**
la première région (a-b) du diélectrique a une cristallinité supérieure à celle de la deuxième région (b-c) , et
une rugosité de surface de ladite première région (a-b) est supérieure à celle de ladite deuxième région (b-c).

2. Condensateur de la revendication 1, dans lequel le diélectrique (3) est un cristal d'oxyde de type pérovskite contenant Ba, Sr, et Ti.

3. Condensateur de la revendication 1, dans lequel le diélectrique a une partie en gradins où une épaisseur de la deuxième région est inférieure à celle de la première région.

4. Condensateur de la revendication 1, dans lequel la deuxième région est disposée de manière à entourer une périphérie de la première région.

5. Condensateur de la revendication 1, dans lequel dans le diélectrique, la deuxième région contient une plus grande quantité d'Ar que la première région.

6. Condensateur de la revendication 1, comprenant en outre un matériau isolant (5) disposé sur la deuxième région du diélectrique et ayant une plus petite constante diélectrique que le diélectrique.

7. Composant haute fréquence comprenant :
un substrat de circuit sur lequel est formé un conducteur ; et
le condensateur de la revendication 1 dont l'électrode supérieure et l'électrode inférieure sont reliées au conducteur.
